# EUROPEAN PATENT APPLICATION

(11) **EP 1 839 833 A1**
(43) Date of publication of application: **03.10.2007**
(21) Application number: 06702660.9
(22) Date of filing: 10.01.2006
(51) Int. Cl.: B29C 43/32, B29C 43/02, D04H 1/54, H05K 3/46

(54) **CUSHIONING MATERIAL FOR HEAT PRESS**

(30) Priority: 14.01.2005 JP 2005008137
(71) Applicant: YAMAUCHI CORPORATION, Hirakata-shi, Osaka 573-1132 (JP)
(72) Inventor: YOSHIDA, Akira, Osaka, 5731132 (JP); OZEKI, Takamitsu, Osaka, 5731132 (JP)
(74) Representative: Hoffmann, Jörg Peter
(86) International application number: PCT/JP2006/300140
(87) International publication number: WO 2006/075573

(57) **Abstract**

A hot-press cushioning material comprises a non-woven fabric made of a fiber web (4). The fiber web (4) comprises a first fiber (4a) containing a first component having a relatively low softening temperature as a main constituent, and a second fiber (4b) containing a second component having a relatively high softening temperature as a main constituent. The non-woven fabric is compressed at a temperature which is not lower than the softening temperature of the first component but lower than the softening temperature of the second component.

## Description

### BACKGROUND OF THE INVENTION

### 1. Field of the Invention

The present invention relates to a hot-press cushioning material, its manufacturing method and a manufacturing method of a laminated board. More particularly, the present invention relates to a hot-press cushioning material used when an object is press formed or thermally compression bonded in a process of manufacturing a precision equipment component (referred to as the laminated board in the present invention hereinafter) such as a printed circuit board such as a copper-clad laminated board, a flexible printed circuit board and a multilayer board, an IC card, a liquid crystal display panel or a ceramics laminated board, its manufacturing method and a manufacturing method of a laminated board using the above cushioning material.

### 2. Description of the Background Art

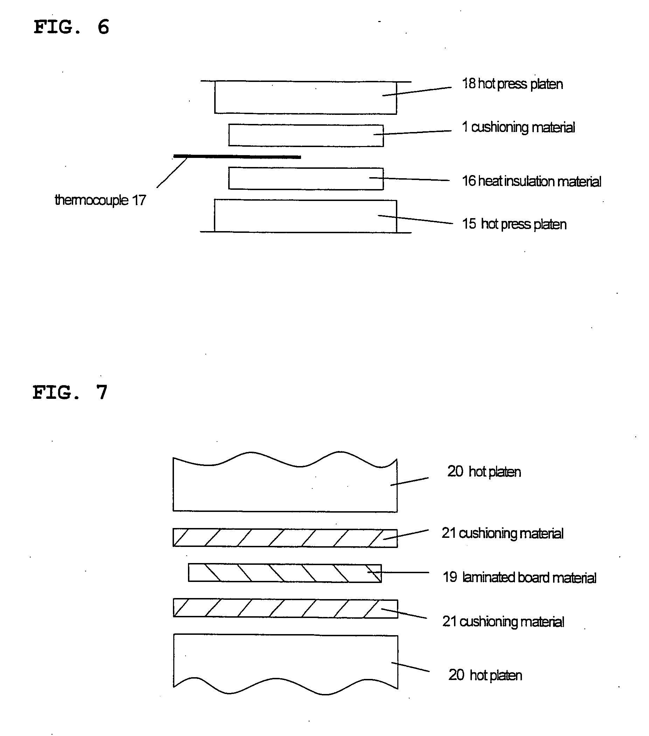

In manufacturing the laminated board such as a printed circuit board, the following method is used in a step of press forming or thermally compression bonding. That is, as shown in Fig. 7, a laminated board material 19 which is an object to be pressed is sandwiched between hot platens 20 and 20 serving as heating and pressurizing means so that a predetermined pressure and heat are applied thereto. In order to provide a high-precision formed object, it is necessary to apply the pressure and heat to the laminated board material 19 uniformly during the hot press. Thus, the hot press is performed with a flat-plate cushioning material 21 interposed between the hot platen 20 and the laminated board material 19.

Here, properties required for the cushioning material 21 includes a cushioning property which absorbs irregularity of the hot platen 20 or the laminated board material 19, a temperature alleviating property which absorbs temperature unevenness of the hot platen 20, a plate thickness precision of the cushioning material 21 itself to transfer the heat and pressure to the laminated board material 19 uniformly, a thickness restoring property to transfer uniform pressure to the laminated board material 19 over an entire surface and maintain a stable cushioning property even after repeatedly used for the press, and the like.

As the hot-press cushioning material 21, various kinds of materials such as sulfate paper, a material in which organic or inorganic fibers are combined with a binder, a rubber, a non-woven fabric, a laminated material comprising a rubber and a non-woven fabric may be used. Except for the sulfate paper, the above material can be repeatedly used for a plurality of press operations in general. Among them, since the cushioning material 21 using the non-woven fabric is superior in absorbing a thickness unevenness of the hot platen or the laminated board material, the non-woven fabric is suitable for a case it is necessary to apply uniform pressure to the entire surface of the laminated board material 19 when a laminated board requiring a precise thickness or a laminated board having irregular surface is press formed.

Such hot-press cushioning material made of the non-woven fabric is disclosed in Japanese Unexamined Patent Publication No. 55-101224, for example. According to Japanese Unexamined Patent Publication No. 55-101224, a laminated needle felt cushioning material in which batt fibers and a foundation cloth are laminated and integrated by a needle punch and finished with a heating process is described. However, the cushioning material made of the non-woven fabric is largely reduced in thickness over time due to fatigue of constitution fibers after it is repeatedly used for the hot press. Thus, it comes to lose its function as the cushioning material gradually, which is an essential problem. In addition, when the thickness of the cushioning material is reduced, a temperature rising speed of the laminated board material becomes inappropriate, so that an air bubble, a plate thickness defect, a warpage, and a thin spot could be generated in the laminated board.

In addition, Japanese Unexamined Patent Publication No. 4-361012 discloses a hot-press cushioning material in which a non-woven fabric is impregnated with a heat resistant resin and hot pressed. According to the cushioning material disclosed in Japanese Unexamined Patent Publication No. 4-361012, its thickness reduction over time can be small even after it is used repeatedly for the hot press. However, since the heat resistant resin enters a gap of the non-woven fabric to solidify a form of the non-woven fabric, the characteristics of the non-woven fabric are lost and a cushioning property could deteriorate.

Furthermore, Japanese Unexamined Patent Publication No. 10-58473 discloses a cushioning material in which a felt-like material using a thermoplastic fiber having a glass transition temperature within a hot-press forming temperature and a softening point, melting point or decomposition point in a temperature range of its forming temperature or higher is heat set at a temperature within the softening point, the melting point or the decomposition point of its constituting fiber. As such thermoplastic fiber, a PPS fiber comprising a polyphenylene sulfide resin and the like is illustrated. In addition, it is described that the heat setting has to be performed in a free state or a low-pressure state. According to the cushioning material described in the patent document, the free state at the time of heat setting serves as a kind of shape-memory property and has thickness restoring property at the time of hot pressing, so that uniform pressure transfer can be provided. However, since the cushioning material in Japanese Unexamined Patent Publication No. 10-58473 contains an air gap like the cushioning material in Japanese Unexamined Patent Publication No. 55-101224, so that it is considered that the reduction in thickness over time is inevitable.

### SUMMARY OF THE INVENTION

It is an object of the present invention to provide a hot-press cushioning material which is stable for a long period without reducing its thickness over time even after repeatedly used for hot press and can provide a preferable cushioning property when used for the hot press, and its manufacturing method

In addition, it is another object of the present invention to provide a manufacturing method of a laminated board, which can manufacture a high-precision laminated board by improving the hot-press cushioning material.

A hot-press cushioning material according to the present invention comprises a non-woven fabric made of a fiber web and it is characterized as follows.

That is, according to one embodiment, it is characterized in that the fiber web comprises a first component having a relatively low softening temperature and a second component having a relatively high softening temperature, and the non-woven fabric is compressed at a temperature which is not lower than the softening temperature of the first component but lower than the softening temperature of the second component.

According to the above embodiment, the first component is a material selected from a group comprising polyethylene, polypropylene, nylon 6, low-melting polyester, acryl, polyvinyl alcohol, and polyphenylene sulfide, and the second component is a material selected from a group comprising nylon 66, polybenzoxazole, polybenzimidazole, polyimide, polyester, polyphenylene sulfide, polytetrafluoroethylene, polyether ether ketone, and phenol. In any combination of the above, it is preferable that the softening temperature of the first component is lower than a hot-press forming temperature of an object to be pressed and the softening temperature of the second component is higher than the hot-press forming temperature of the object to be pressed.

According to another embodiment, it is characterized in that the fiber web comprises a first component having a softening temperature and a second component having no softening temperature, and the non-woven fabric is compressed at the softening temperature of the first component or higher.

According to the above embodiment, for example, the first component is a material selected from a group comprising polyethylene, polypropylene, nylon 6, low-melting polyester, acryl, polyvinyl alcohol, and polyphenylene sulfide, and the second component is a material selected from a group comprising aromatic polyamide, polyamideimide, polyarylate, metal, carbon, silica, glass, and ceramics. In this case, preferably, the softening temperature of the first component is lower than a hot-press forming temperature of an object to be pressed.

The hot-press cushioning material is provided as follows. That is, a manufacturing method of a hot-press cushioning material comprising a compressed non-woven fabric according to the present invention comprises a step of preparing a non-woven fabric made of a fiber web comprising a thermoplastic first component having a softening temperature and a heat-resistant second component having a softening temperature higher than the softening temperature of the first component or having no softening temperature, a step of compressing the non-woven fabric at the softening temperature of the first component or higher, a step of cooling the non-woven fabric to a temperature lower than the softening temperature of the first component in a compressed state, and a step of releasing the compressed state of the non-woven fabric after cooled.

In manufacturing the compressed non-woven fabric, when the non-woven fabric made of the fiber web containing the first component and the second component is compressed at the temperature of the softening temperature of the first component or higher, the first component is softened or melted. Since the second component has the softening temperature higher than the compression process temperature or has no softening temperature, the second component retains elastic restoring force even after the compressed process. Then, when it is cooled down to the temperature lower than the softening temperature of the first component in the compressed state, the first component is solidified and since the solidified first component restrains the second component which maintains the elastic restoring force in the compressed state, even when the compression is released, the compressed state of the non-woven fabric is maintained. Thus, since the hot-press cushioning material according to the present invention is in the compressed state from an early stage as compared with the conventional cushioning material made of the non-woven fabric, reduction in thickness over time is small and its properties can be kept stable for a long period of time.

The hot-press forming is performed by applying pressure and heat with the cushioning material interposed between the hot platen and the laminated board material which is the object to be pressed. At this time, a prepreg of the laminated board material is hardened into a predetermined configuration through a flowing state. Then, it is cooled down while being pressurized and then pressing is released. When the cushioning material according to the present invention is heated to the hot-press forming temperature in use, the first component is softened or melted, so that the compressed second component is released from the first component and provides the thickness restoring property. This thickness restoring property absorbs the thickness unevenness of the hot platen or the object to be pressed and transfers the uniform pressurizing force. When it is cooled down in the pressurized state and the pressing is released, the cushioning material is fixed in the compressed state again.

According to one embodiment, the fiber web is provided such that a first fiber comprising the first component as a main constituent and a second fiber comprising the second component as a main constituent are mixed. In this case, it is preferable that a mixture ratio of the first fiber to the second fiber is 5/95 to 70/30 by mass. When the mixture ratio of the first fiber is too small, the first fiber cannot fully restrain the second fiber in the compressed state. Meanwhile, when the mixture ratio of the second fiber is too small and the mixture ratio of the first fiber is too much, the thickness restoring performance when it is used becomes insufficient and a molten first fiber comes out of the cushioning material and could have adverse effect. More preferably, the mixture ratio of the first fiber to the second fiber is 10/90 to 70/30 by mass.

Preferably, the first fiber has a core-in-sheath structure consisting of a core part comprising the first component and a coating part comprising the second component. According to the fiber having such core-in-sheath structure, the entire fiber is softened because the core part is softened by heat at the time of press forming and the first fiber releases the second fiber. In addition, since the core part having the low softening temperature is covered with the heat-resistant coating part, the molten first fiber can be prevented from coming out when the cushioning material is used.

In addition, according to another embodiment, the fiber web may only comprise a fiber having a core-in-sheath structure consisting of a core part comprising the first component and a coating part comprising the second component. In this case, since the fiber having the core-in-sheath structure itself contains the first and second components, the core part of the fiber is softened by the heat at the time of the hot press forming to release the restraint of the coating part. A material for the part is to be selected so that the softened or melted core part is prevented from coming out in consideration of the following points, for example. That is, according to one aspect to be considered, a material which is superior in heat resistance, in strength and elastic restoring force is to be selected for the coating part. According to another aspect to be considered is that a difference between the softening temperature of the material for the core part and the hot-press forming temperature is not to be too large.

In either of the above embodiments, it is preferable that the non-woven fabric is provided such that the fiber web and a woven fabric comprising the equal component as the second component are needlepunched. Thus, dimension stability of the non-woven fabric is improved. In addition, the term "the equal component as the second component" means that it is a heat-resistant component having the softening temperature higher than that of the first component or a heat-resistant component having no softening temperature.

The hot-press cushioning material according to the present invention may have a laminated structure in which the surface coating material is laminated on the compressed non-woven fabric.

A manufacturing method of a laminated board according to the present invention comprises a step of heating and pressurizing the laminated board with a flat plate cushioning material interposed between the laminated board and heating and pressurizing means and it is characterized in that the cushioning material is the hot-press cushioning material comprising the compressed non-woven fabric. Since the laminated board is manufactured using the cushioning material comprising the compressed non-woven fabric, the reduction in thickness over time of the cushioning material is small as described above. Therefore, even after the pressing is repeated, the laminated board can be manufactured at an appropriate temperature rising speed over a long period of time. According to the hot-press forming, when heat and pressure are applied with the cushioning material interposed between the hot platen and the laminated board material to be pressed, the prepreg of the laminated board material can be cured into the predetermined configuration through its flowing state. At this time, the first component contained in the cushioning material is softened as the temperature is raised and the thickness restoring property is provided in the cushioning material. As the temperature is further raised, although the prepreg of the laminated board material comes to flow, since the cushioning material has the thickness restoring property at this time, it absorbs the thickness unevenness of the hot platen or the laminated board material, so that uniform pressurizing force can be transmitted to the laminated board material. Thus, according to the manufacturing method of the laminated board, a high-quality laminated board having no air bubble, no plate thickness defect, no warpage, or no thin spot can be stably manufactured.

### BRIEF DESCRIPTION OF THE DRAWINGS

Fig. 1 is a sectional view showing a hot-press cushioning material according to the present invention;
Fig. 2 is an explanatory view showing a fiber having a core-in-sheath structure;
Fig. 3 is a schematic view illustrating an operation principle of a compressed non-woven fabric;
Fig. 4 is an explanatory view showing a manufacturing method of a laminated board according to the present invention;
Fig. 5 is an explanatory view showing an apparatus to measure a cushioning property of the cushioning material;
Fig. 6 is an explanatory view showing an apparatus to measure a heat insulating property of the cushioning material; and
Fig. 7 is an explanatory view showing a general manufacturing method of a laminated board.

### DESCRIPTION OF THE PREFERRED EMBODIMENTS

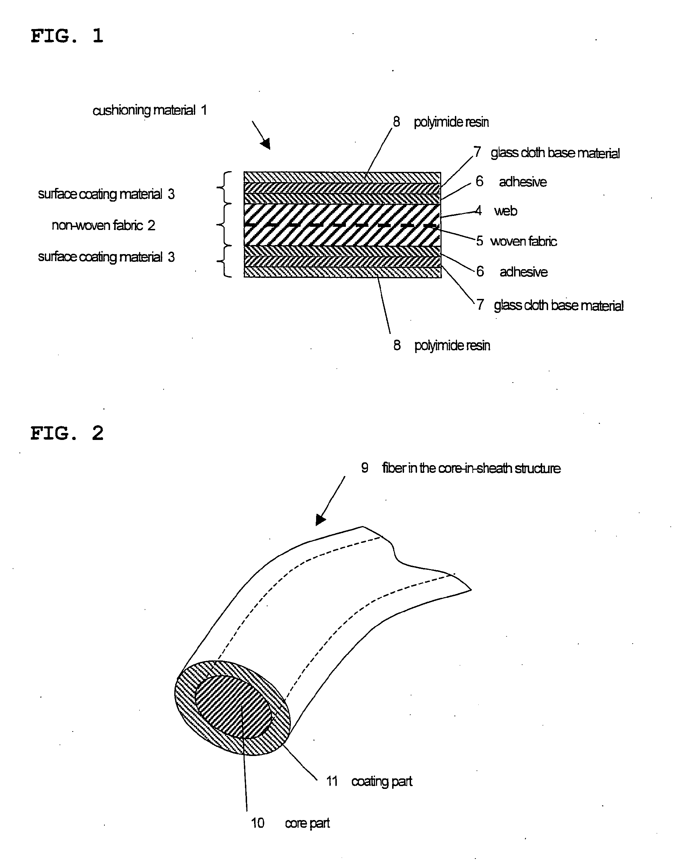

Fig. 1 is a sectional view showing an example of a hot-press cushioning material 1 according to the present invention. The cushioning material 1 comprises a sheet-shaped compressed non-woven fabric 2 in the center and a surface coating material 3 laminated on each of upper and lower surfaces thereof. The compressed non-woven fabric 2 is provided such that a non-woven fabric formed of a fiber web comprising a thermoplastic first component having a softening temperature lower than a hot-press forming temperature of an object to be pressed, and a heat-resistant second component having a softening temperature higher than the hot-press forming temperature of the object to be pressed or having no softening temperature is compressed at a temperature which is not lower than the softening temperature of the first component. More specifically, the fiber web is a web in which a first fiber comprising the first component as a main constituent and a second fiber comprising the second component as a main constituent are mixed. Here, although the press forming temperature of a laminated board is within a range of 150°C to 300°C in general, that temperature is set depending on the kind of the laminated board to be pressed or a manufacturer of the laminated board.

The kind of the first component is not particularly limited as long as it is the thermoplastic component having the softening temperature lower than the hot-press forming temperature. For example, polyethylene, polypropylene, nylon 6, low melting point polyester (L-PET), acryl, polyvinyl alcohol, polyphenylene sulfide (PPS) and the like are used. Thus, a preferable component can be selected depending on a press condition of the object to be pressed from the above.

The second component is also not particularly limited as long as it has the softening temperature higher than the hot-press forming temperature or does not have the softening temperature. The component having the softening temperature higher than the press forming temperature includes nylon 66, polybenzoxazole (PBO), polybenzimidazole (PBI), polyimide, polyester, polyphenylene sulfide (PPS), polytetrafluoroethylene (PTFE), polyether ether ketone (PEEK), phenol and the like. The component having no softening temperature includes aromatic polyamide, polyamideimide, polyarylate, metal, carbon, silica, glass, ceramics and the like.

Although a fiber comprising a single material of the above first component is used as the first fiber in general, as a variation of the fiber comprising the first component as the main constituent, even when a fiber 9 shown in Fig. 2 is used, a preferable result can be provided. The fiber 9 shown in Fig. 2 has a core-in-sheath structure consisting of a core part 10 comprising the first component and a coating part comprising the second component. Thus, the fiber 9 is composed of the first component which is a main constituent and the second component. Here, the first component has softening temperature characteristics lower than the hot-press forming temperature and the second component has softening temperature characteristics higher than the hot-press forming temperature or does not have the softening temperature. Since the fiber 9 has the first component as the main constituent, it is softened as a whole at the time of hot-press forming and solidified when it is cooled to restrain the second fiber.

Although the second fiber is also formed of a single material of the second component in general, it may be a composite fiber having a core-in-sheath structure and the like in which the second component is a main constituent. In this case, since the second fiber has the second component as the main constituent, it is not softened as a whole at the time of hot-press forming and it is released from the first component and provides a thickness restoring characteristics.

In addition, the component as the "main constituent" in the descriptions of the first and second fibers means a component which makes one of the first and second fibers bring out a characteristic thermal property which is different from that of the other of the fiber in a composite structure such as the core-in-sheath structure.

Each of the first and second fibers may be formed of a single fiber, or may be formed of two or more kinds of fibers.

The non-woven fabric 2 is provided such that the web 4 in which the first fiber and the second fiber are mixed in a ratio of 5/95 to 70/30 by mass is needlepunched together with a woven fabric 5 comprising the equal component as that of the second fiber, and it is compressed at the softening temperature of the first fiber or higher. The compressed process may be performed in a pressing process of integrating the non-woven fabric 2 and the surface coating material 3 as will be described below.

As the surface coating material 3, a film, a woven fabric, paper, foil, a sheet, or a plate formed of a heat resistant organic or inorganic material may be appropriately used depending on its usage. The above material having adhesiveness on one surface with an adhesive and the like may be applied to the non-woven fabric 2. Alternatively, according to one example of the film, a liquid resin may be coated. According to the embodiment shown in Fig. 1, as the surface coating material 3, a fluoro rubber adhesive 6 is applied to one surface (bonding surface) of a glass cloth base material 7, and a polyimide resin 8 is coated on the other surface.

The surface coating material 3 may be omitted from the cushioning material 1 when bleeding due to melting of the first fiber or a nap of the non-woven fabric does not matter. In addition, other than the non-woven fabric 2 and the surface coating material 3, another layer such as an elastic layer or an reinforcing layer comprising a rubber, a fiber-reinforced rubber, a fiber-reinforced resin may be laminated. When the other layer is laminated, it may be interposed between the non-woven fabric 2 and the surface coating material 3 or may be interposed between the non-woven fabrics 2.

The non-woven fabric 2 which constitutes the cushioning material 1 may have the following constitution as a variation. That is, according to the fiber 9 in the core-in-sheath structure shown in Fig. 2, since the core part 10 comprises the first component and the coating part 11 comprises the second component, the fiber 9 itself comprises the first and second components. Therefore, the non-woven fabric 2 may be formed of a web using the fiber 9 in the core-in-sheath structure, so that it is not necessary to mix the first and second fibers as described above.

Next, a manufacturing method of the cushioning material 1 will be described. First, the first fiber and the second fiber are mixed in a ratio of 5/95 to 70/30 by mass to prepare a mixed web 4. Then, the woven fabric 5 is arranged between the two-layer mixed webs 4 and needlepunched to form the non-woven fabric 2. Then, the surface coating material 3 separately prepared is laminated on each of the upper and lower surfaces of the non-woven fabric 2. Here, the fluoro rubber thermo-sensitive adhesive 6 has been applied to one surface (bonding surface) of the surface coating material 3. This laminated material is hot pressed and compressed at the softening temperature of the first fiber or higher. In this hot pressing, the non-woven fabric 2 and the surface coating material 3 are bonded and the first fiber is softened. Then, it is cooled down to a temperature lower than the softening temperature of the first fiber with water and the like while the compressed state is maintained. Thus, the first fiber is solidified to restrain the second fiber while it is kept in the compressed state. Finally, the compressed state is released. The thus-provided non-woven fabric 2 of the cushioning material 1 has a small thickness as compared with the conventional non-woven fabric of the cushioning material, that is, the non-woven fabric which comprises only the heat-resistant second fiber without comprising the first fiber.

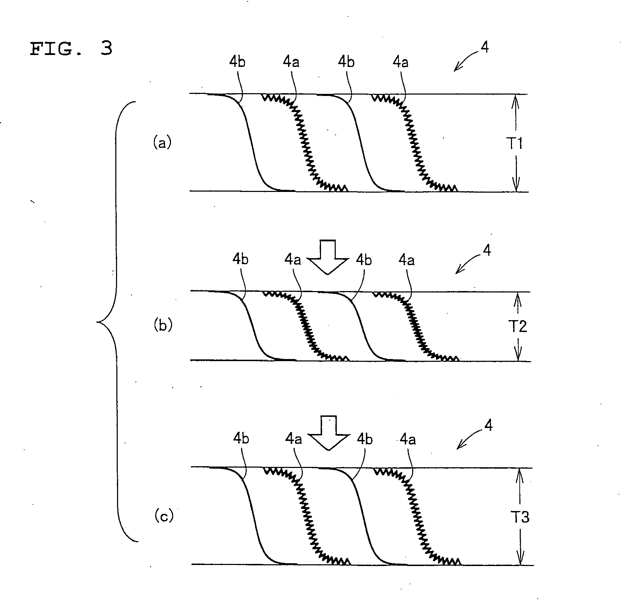

Referring to Fig. 3, an operation principle of the compressed non-woven fabric is illustrated. Fig. 3 illustrates variations of the fiber web 4 comprising a first fiber 4a comprising the first component as the main constituent and a second fiber 4b comprising the second component as the main constituent, in which. Fig. 3(a) shows a state before it is compressed, Fig. 3(b) shows a state after it is compressed, and Fig. 3(c) shows a state it is heated at the time of hot-press forming.

Although the first fiber 4a and the second fiber 4b are schematically illustrated in Fig. 3 in order to simply show the operation principle, the first and second fibers 4a and 4b are tangled at random actually.

Before the web 4 is compressed, the first fiber 4a and the second fiber 4b are mixed and the fiber web 4 has a predetermined thickness T1. When the fiber web 4 is compressed in a thickness direction at the softening temperature of the first fiber 4a or higher, the thickness of the fiber web 4 is reduced. At this time, the second fiber having heat resistance higher than the compression process temperature retains elastic restoring force. Then, when the first fiber 4a is cooled down to the temperature lower than its softening temperature in the compressed state, the first fiber 4a is solidified again. Then, the compressed state is released. In this state, as shown in Fig. 3(b), since the solidified first fiber 4a restrains the second fiber 4b, the thickness of the fiber web 4 is reduced from T1 to T2. When the fiber web 4 is heated to the softening temperature of the first fiber 4a or higher at the time of hot-press forming as shown in Fig. 3(c), since the first fiber 4a is softened and release the second fiber 4b, the second fiber 4b provides the thickness restoring property, so that the thickness of the fiber web 4 is increased from T2 to T3. Since a pressure is applied by a hot platen to the fiber web 4 at the time of hot-press forming, although the thickness of the fiber web 4 is not increased actually, the same cushioning property as that of the fiber web 4 having the thickness T3 is provided for the object to be pressed.

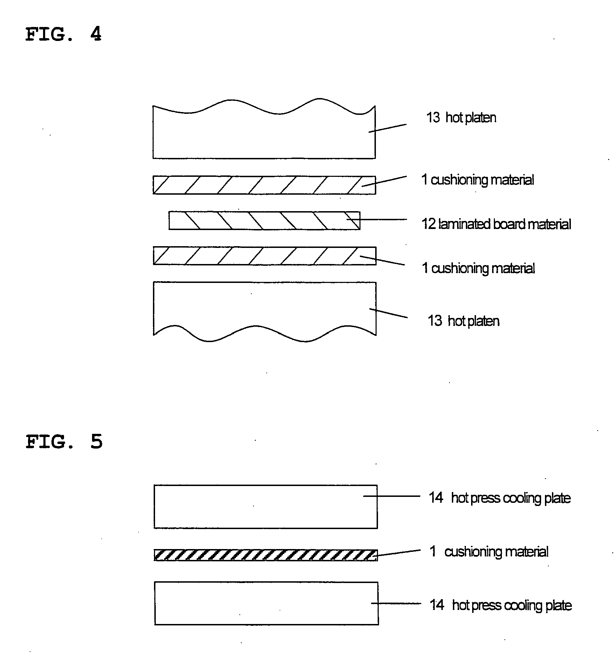

Next, a manufacturing method of a laminated board will be described. With the cushioning material 1 according to the present invention, the laminated board can be manufactured by the same method as the conventional method. That is, as shown in Fig. 4, the cushioning material 1 according to the present invention is interposed between the laminated board material 12 comprising a printed-circuit prepreg and the like and the hot platens 13 and 13, and pressurized, heated, cooled and depressurized for a predetermined time. Thus, the prepreg of the laminated board material is made to flow and cured, whereby the laminated board is manufactured.

### [Working Example]

In order to confirm an effect of the present invention, the comparison experiment was performed as follows. The cushioning material used in the experiment has the structure shown in Fig. 1 and samples 1 to 7 of the cushioning materials were made as follows. In addition, each cushioning material is supposedly used when a glass base epoxy resin laminated board using an epoxy resin prepreg which starts to flow at 120°C is formed by hot press at 190°C.

First, a reinforcing woven fabric was arranged between the mixed web layers in which a first fiber and a second fiber were mixed in a predetermined ratio and needle-punched to form a non-woven fabric having a weight of 650g/m². The followings were used for each material.

### [First fiber]

Structure : A polyester fiber comprising a core part is formed of low-melting polyester (softening temperature is 118°C) and a coating part formed of polyester (softening temperature is 264°C) in a core-in-sheath structure.
Size : 4.4d
Fiber length : 51mm

### [Second fiber]

Structure : Meta aromatic polyamide fiber which is non-thermoplastic
Size : 2.2d
Fiber length : 51mm

### [Reinforcing woven fabric]

Structure : Plain woven fabric made of polyester (softening temperature is 245°C)
Weight : 80g/m²

Here, the mixing ratio of the first and second fibers were varied as shown in a table 1 and seven kinds of non-woven fabrics were made.

**[Table 1]**

| mixing ratio of the first and second fibers (by mass) | | | | | | | |
|---|---|---|---|---|---|---|---|
| | non-woven fabric 1 | non-woven fabric 2 | non-woven fabric 3 | non-woven fabric 4 | non-woven fabric 5 | non-woven fabric 6 | non-woven fabric 7 |
| first fiber | 0 | 5 | 10 | 30 | 50 | 70 | 90 |
| second fiber | 100 | 95 | 90 | 70 | 50 | 30 | 10 |

Then, the surface coating material was laminated on each of upper and lower surfaces of the non-woven fabric and they were pressed to be integrated under the following condition to provide seven samples 1 to 7 corresponding to the above non-woven fabrics 1 to 7, respectively.
Heating : 185°C for 60 minutes
Cooling : 15 minutes
Pressure : 2MPa

As the surface coating material, a sheet in which a fluoro rubber adhesive had been applied to one surface (bonding surface) of a glass cloth base material having a thickness of 0.2mm and a polyimide resin had been coated on the other surface was used.

A cushioning property, a heat insulating property and a thickness restoring property of each cushioning material of the sample were compared.

### [Cushioning property]

As shown in Fig. 5, after the cushioning material 1 is arranged between the upper and lower heating-cooling press plates 14 and heated at 190°C for 100 minutes under pressure of 4MPa, it is cooled down with water for 20 minutes under the same pressure and depressurized. Thus, the above press cycle was repeated 100 times. A thickness change of the cushioning material 1 before pressurized and during pressurized was used as an indicator for the cushioning property and how the cushioning property was changed was measured after the above press cycles. Its result is shown in a table 2.

**[Table 2]**

| | cushioning property (µm) | | | heat insulating property | | | thickness restoring property | |
|---|---|---|---|---|---|---|---|---|
| | press 0 time | press 10 times | press 100 times | press 0 time | press 10 times | press 100 times | before heating (mm) | restored amount (mm) |
| sample 1 | 300 | 90 | 75 | 100 | 80 | 60 | 1.90 | 0.08 |
| sample 2 | 230 | 80 | 75 | 80 | 65 | 55 | 1.60 | 0.87 |
| sample 3 | 120 | 80 | 70 | 70 | 60 | 55 | 1.44 | 0.77 |
| sample 4 | 85 | 75 | 65 | 65 | 55 | 50 | 1.17 | 0.65 |
| sample 5 | 70 | 65 | 60 | 55 | 50 | 50 | 0.95 | 0.53 |
| sample 6 | 65 | 65 | 60 | 50 | 50 | 45 | 0.82 | 0.47 |
| sample 7 | 60 | cannot be measured due to bleeding | | 45 | cannot be measured due to bleeding | | 0.66 | 0.38 |

As can be clear from the table 2, in the case of the sample 1 which does not comprise the first fiber but comprises only the second fiber, the cushioning property is considerably lowered. Meanwhile, in the case of the samples 2 to 6 which comprise 5 to 70% first fiber, the cushioning property is lowered a little. Especially, in the case of the samples 3 to 6 which comprise 10 to 70% first fiber, the lowering of the cushioning property is smaller. In the case of the sample 7 which comprise 90% first fiber, its cushioning property could not be measured due to bleeding.

### [Heat insulating property]

As shown in Fig. 6, a hot press platen (30°C) 15, a heat insulation material (heat resistance is 52. 52 sec· °C/cal) 16, a thermocouple 17 and the cushioning material 1 were piled up from beneath and pressed by a hot press platen (185°C) 18 at a pressure of 4MPa from above. Thus, a temperature transferred to the thermocouple 17 was read. Its result is shown in the table 2 such that it is compared with a measured temperature of the sample 1 at the first press which is set to 100.

As can be clear from the table 2, it is confirmed that a variation of the heat insulating property is small in the samples 2 to 6. Especially, the variation of the heat insulating property is small in the samples 3 to 6.

### [Thickness restoring property]

Each cushioning material was put in an oven at 180°C for 30 minutes under no pressure and a thickness restoring amount was measured. A thickness before heating and a thickness restored amount after the heating are shown in the table 2.

As can be clear from the table 2, it is confirmed that the thickness restoring property is great in the samples 2 to 7.

Although the embodiments of the present invention have been described with reference to the drawings in the above, the present invention is not limited to the above-illustrated embodiments. Various kinds of modifications and variations may be added to the illustrated embodiments within the same or equal scope of the present invention.

Thus, the hot-press cushioning material according to the present invention can be used as a cushioning material when an object is press formed or thermally compression bonded in a process of manufacturing a laminated board such as a printed circuit board such as a copper-clad laminated board, a flexible printed circuit board and a multilayer board, an IC card, a liquid crystal display panel or a ceramics laminated board. In addition, the present invention provides the manufacturing method of the hot-press cushioning material. Furthermore, the present invention provides the manufacturing method of the laminated board using the hot-press cushioning material.

## Claims

1. A hot-press cushioning material comprising a non-woven fabric formed of a fiber web, **characterized in that** said fiber web comprises a first component having a relatively low softening temperature and a second component having a relatively high softening temperature, and
said non-woven fabric is compressed at a temperature which is not lower than the softening temperature of the first component but lower than the softening temperature of the second component.

2. A hot-press cushioning material comprising a non-woven fabric formed of a fiber web, **characterized in that** said fiber web comprises a first component having a softening temperature and a second component having no softening temperature, and
said non-woven fabric is compressed at the softening temperature of the first component or higher.

3. The hot-press cushioning material according to claim 1, wherein said softening temperature of the first component is lower than a hot-press forming temperature of an object to be pressed and said softening temperature of the second component is higher than the hot-press forming temperature of the object to be pressed.

4. The hot-press cushioning material according to claim 2, wherein said softening temperature of the first component is lower than a hot-press forming temperature of an object to be pressed.

5. The hot-press cushioning material according to claim 1, wherein said first component is a material selected from a group comprising polyethylene, polypropylene, nylon 6, low-melting polyester, acryl, polyvinyl alcohol, and polyphenylene sulfide, and
said second component is a material selected from a group comprising nylon 66, polybenzoxazole, polybenzimidazole, polyimide, polyester, polyphenylene sulfide, polytetrafluoroethylene, polyether ether ketone, and phenol.

6. The hot-press cushioning material according to claim 2, wherein said first component is a material selected from a group comprising polyethylene, polypropylene, nylon 6, low-melting polyester, acryl, polyvinyl alcohol, and polyphenylene sulfide, and
said second component is a material selected from a group comprising aromatic polyamide, polyamideimide, polyarylate, metal, carbon, silica, glass, and ceramics.

7. The hot-press cushioning material according to claim 1, wherein said fiber web is provided such that a first fiber comprising said first component as a main constituent and a second fiber comprising said second component as a main constituent are mixed.

8. The hot-press cushioning material according to claim 7, wherein a mixture ratio of said first fiber to said second fiber is 5/95 to 70/30 by mass.

9. The hot-press cushioning material according to claim 7, wherein said first fiber has a core-in-sheath structure consisting of a core part comprising said first component and a coating part comprising said second component.

10. The hot-press cushioning material according to claim 1, wherein said fiber web comprises a fiber having a core-in-sheath structure consisting of a core part comprising said first component and a coating part comprising said second component.

11. The hot-press cushioning material according to claim 1, wherein said non-woven fabric is provided such that said fiber web and a woven fabric comprising the equal component as said second component are needlepunched.

12. The hot-press cushioning material according to claim 1, comprising a surface coating material laminated on said non-woven fabric.

13. A manufacturing method of a hot-press cushioning material comprising a compressed non-woven fabric, comprising:
a step of preparing a non-woven fabric made of a fiber web comprising a thermoplastic first component having a softening temperature and a heat-resistant second component having a softening temperature higher than the softening temperature of said first component or having no softening temperature;
a step of compressing said non-woven fabric at the softening temperature of said first component or higher;
a step of cooling said non-woven fabric to a temperature lower than the softening temperature of said first component in a compressed state; and
a step of releasing the compressed state of said non-woven fabric after cooled.

14. The manufacturing method of the hot-press cushioning material according to claim 13, wherein said fiber web is provided such that a first fiber comprising said first component as a main constituent and a second fiber comprising said second component as a main constituent are mixed.

15. The manufacturing method of the hot-press cushioning material according to claim 14, wherein a mixture ratio of said first fiber to said second fiber is 5/95 to 70/30 by mass.

16. The manufacturing method of the hot-press cushioning material according to claim 14, wherein said first fiber has a core-in-sheath structure consisting of a core part comprising said first component and a coating part comprising said second component.

17. The manufacturing method of the hot-press cushioning material according to claim 13, wherein said fiber web comprises a fiber having a core-in-sheath structure consisting of a core part comprising said first component and a coating part comprising said second component.

18. The manufacturing method of the hot-press cushioning material according to claim 13, wherein said non-woven fabric is provided such that said fiber web and a woven fabric comprising the equal component as said second component are needlepunched.

19. The manufacturing method of the hot-press cushioning material according to claim 13, wherein a surface coating material is laminated on said non-woven fabric to be integrated.

20. A manufacturing method of a laminated board comprising a step of heating and pressurizing the laminated board with a flat-plate cushioning material interposed between the laminated board and heating and pressurizing means, **characterized in that** said cushioning material is the hot-press cushioning material according to claim 1.
